# EUROPEAN PATENT APPLICATION

(11) **EP 4 518 165 A1**
(43) Date of publication of application: **05.03.2025**
(21) Application number: 22949323.4
(22) Date of filing: 28.06.2022
(51) Int. Cl.: H03M 13/19

(54) **DECODING DEVICE, CONTROL CIRCUIT, STORAGE MEDIUM, AND CHECK MATRIX GENERATION METHOD**

(71) Applicant: MITSUBISHI ELECTRIC CORPORATION, Chiyoda-ku Tokyo 100-8310 (JP)
(72) Inventor: NAKAMURA, Takahiko, Tokyo 100-8310 (JP)
(74) Representative: Plasseraud IP
(86) International application number: PCT/JP2022/025822
(87) International publication number: WO 2024/004047

(57) **Abstract**

A decoding device (320) includes a storage unit (331) storing a first check matrix with a highest code rate that can be divided into blocks of P×P submatrices, the highest code rate being conceivable as a check matrix of a low-density parity-check code used in communication, where P is a positive integer; and a generation unit (332) that generates, using a unit row of the first check matrix that includes submatrices in column directions, a first row where some blocks are replaced with zero matrices and at least one second row where specified blocks are replaced with zero matrices, with the other blocks of submatrices having 1s shifted by a specified fixed value, to generate a second check matrix with a lower code rate than the first check matrix.

## Description

### Field

The present disclosure relates to a decoding device, a control circuit, a storage medium, and a check matrix generation method for use in a communication apparatus.

### Background

Communication apparatuses have switched between plural low-density parity-check codes (hereinafter referred to as LDPC codes) of the same code length but different code rates when performing encoding and decoding. For example, Patent Literature 1 discloses a technique that realizes LDPC codes of plural rates by generating a new parity check matrix for which some or all of rows of a parity check matrix of an LDPC code are each divided into two or more rows, with "1s" allocated among the two or more divided rows on a condition that row vectors of the parity check matrix resulting from the row division are linearly independent with respect to positions of "1s" in a row of the original parity check matrix.

### Citation List

### Patent Literature

Patent Literature 1: Japanese Patent Application Laid-open No. 2011-109228

### Summary

### Technical Problem

However, a problem with the above conventional technique is that performance may not sufficiently improve. This is because the newly generated parity check matrix has an increased number of rows, which results in a decreased row weight compared to the original parity check matrix, and faces a limitation on a maximum value of column weight when having increased columns in the parity check matrix to lower the code rate. Another problem is that with the newly generated check matrix, error floor often occurs at a high error ratio.

The present disclosure has been made in view of the above, and an object of the present disclosure is to obtain a decoding device that allows for restrained degradation of code performance when a check matrix has increased rows.

### Solution to Problem

In order to solve the above-described problems and achieve the object, a decoding device of the present disclosure comprises a storage unit to store a first check matrix with a highest code rate that can be divided into blocks of P×P submatrices, the highest code rate being conceivable as a check matrix of a low-density parity-check code used in communication, where P is a positive integer; and a generation unit to generate, using a unit row of the first check matrix that includes the submatrices in column directions, a first row where some blocks are replaced with zero matrices and at least one second row where specified blocks are replaced with zero matrices, with other blocks of submatrices having 1s shifted by a specified fixed value, to generate a second check matrix with a lower code rate than the first check matrix.

### Advantageous Effects of Invention

The decoding device according to the present disclosure has an effect of enabling restrained degradation of code performance when the check matrix has increased rows.

### Brief Description of Drawings

FIG. 1 is a diagram illustrating an exemplary configuration of a communication system including communication apparatuses according to a first embodiment.
FIG. 2 is a diagram illustrating an example of an addition method by which a check matrix generation device according to the first embodiment adds rows of a parity check matrix.
FIG. 3 is a flowchart illustrating how the check matrix generation device according to the first embodiment operates.
FIG. 4 is a diagram illustrating an exemplary configuration of processing circuitry configured with a processor and a memory as processing circuitry that implements the communication apparatus according to the first embodiment.
FIG. 5 is a diagram illustrating an example of processing circuitry configured as dedicated hardware to serve as the processing circuitry that implements the communication apparatus according to the first embodiment.
FIG. 6 is a diagram illustrating an exemplary configuration of the communication system including the communication apparatuses according to a second embodiment.
FIG. 7 is a diagram illustrating an exemplary configuration of a row operation unit included in a decoding unit according to the second embodiment.
FIG. 8 is a flowchart illustrating how the row operation unit of the decoding unit according to the second embodiment performs a row operation.
FIG. 9 is a diagram illustrating an exemplary configuration of a column operation unit included in the decoding unit according to a third embodiment.
FIG. 10 is a flowchart illustrating how the column operation unit of the decoding unit according to the third embodiment performs a column operation.

### Description of Embodiments

With reference to the drawings, a detailed description is hereinafter provided of a decoding device, a control circuit, a storage medium, and a check matrix generation method according to embodiments of the present disclosure.

### First Embodiment.

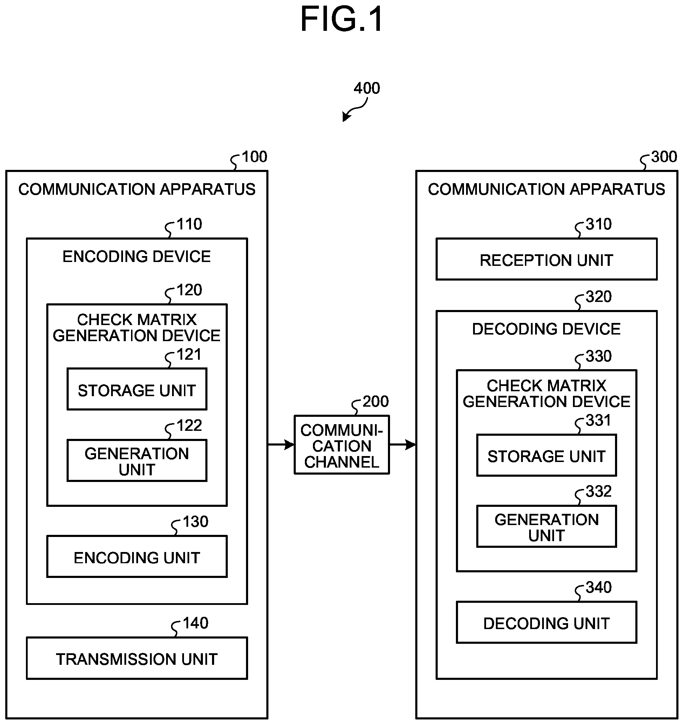

FIG. 1 is a diagram illustrating an exemplary configuration of a communication system 400 including communication apparatuses 100 and 300 according to a first embodiment. The communication system 400 is a system where the communication apparatus 100 transmits a signal encoded using an LDPC code to the communication apparatus 300 over a communication channel 200, and the communication apparatus 300 decodes the received signal. The communication apparatus 100 includes an encoding device 110 and a transmission unit 140. The encoding device 110 includes a check matrix generation device 120 and an encoding unit 130. The check matrix generation device 120 includes a storage unit 121 and a generation unit 122. The communication apparatus 300 includes a reception unit 310 and a decoding device 320. The decoding device 320 includes a check matrix generation device 330 and a decoding unit 340. The check matrix generation device 330 includes a storage unit 331 and a generation unit 332.

The encoding device 110 of the communication apparatus 100 encodes communication bits obtained from a higher-level device (not illustrated) or the like. In the encoding device 110, the check matrix generation device 120 generates a parity check matrix to be used in the encoding of the communication bits. The encoding unit 130 obtains the parity check matrix from the check matrix generation device 120 and encodes the communication bits. The transmission unit 140 performs modulation or the like on the communication bits encoded by the encoding unit 130 of the encoding device 110 and transmits the modulated signal over the communication channel 200 to the communication apparatus 300. The parity check matrix may be simply referred to as the check matrix when described below.

The reception unit 310 of the communication apparatus 300 performs demodulation or the like on the received signal received over the communication channel 200 from the communication apparatus 100. The decoding device 320 decodes the demodulated signal and generates and outputs to a higher-level device (not illustrated) or the like a decoding result. In the decoding device 320, the check matrix generation device 330 generates a parity check matrix to be used in the decoding of the demodulated signal. The decoding unit 340 obtains the parity check matrix from the check matrix generation device 330 and decodes the demodulated signal.

In the first embodiment, a description is provided of a method in which the check matrix generation device 120 of the communication apparatus 100 and the check matrix generation device 330 of the communication apparatus 300 each add rows to an original parity check matrix to generate a parity check matrix with a different code rate from the original parity check matrix. The check matrix generation device 120 and the check matrix generation device 330 have the same configuration. The storage unit 121 and the generation unit 122 of the check matrix generation device 120 are configured the same as the storage unit 331 and the generation unit 332 of the check matrix generation device 330. Since the check matrix generation devices 120 and 330 operate in the same manner, the check matrix generation device 330 is taken as an example and described below.

LDPC codes handled here in the first embodiment are systematic codes. When the parity check matrix is an m×n matrix, the rightmost m columns of the parity check matrix correspond to parity bits. It is to be noted that m and n are positive integers. However, column positions that correspond to positions of the parity bits may be appropriately changed. In the first embodiment, the decoding device 320 that includes the check matrix generation device 330 performs LDPC code decoding using a check matrix for encoding, which is an encoding matrix formed by transforming a parity check matrix into a lower triangular matrix. The check matrix generation device 330 is capable of varying the LDPC code rate by progressively adding rows of a parity check matrix to a base parity check matrix of a LDPC code with the highest code rate.

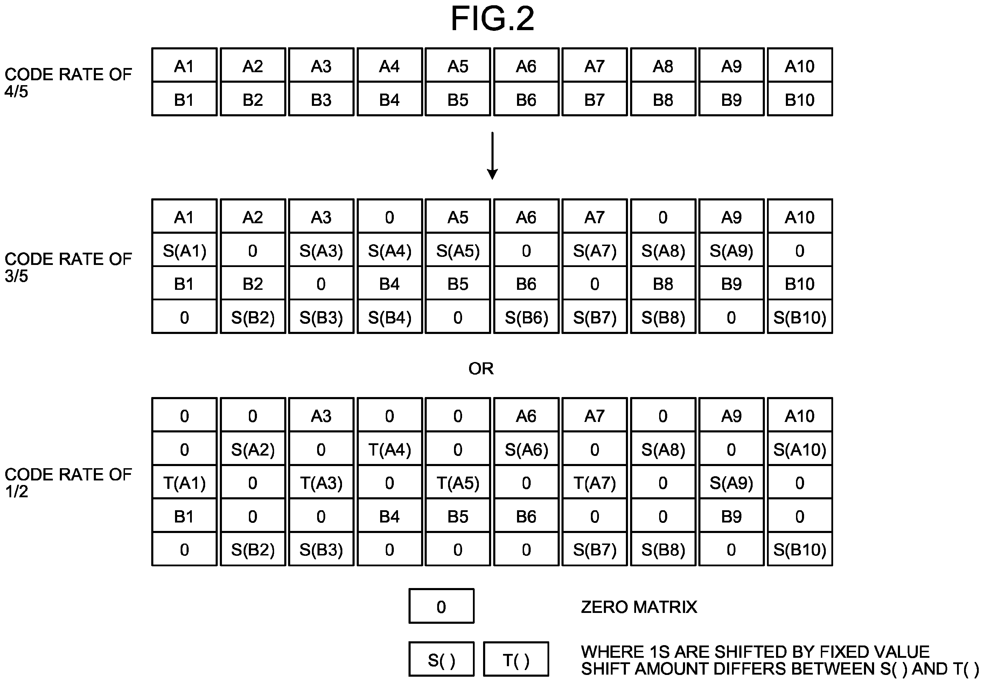

FIG. 2 is a diagram illustrating an example of an addition method by which the check matrix generation device 330 according to the first embodiment adds rows of a parity check matrix. In FIG. 2, a top parity check matrix with a code rate of 4/5 is prestored in the storage unit 331 and refers to the base parity check matrix of the LDPC code with the highest code rate. A middle parity check matrix with a code rate of 3/5 is generated by the generation unit 332, using the parity check matrix with the code rate of 4/5 to add two rows. A bottom parity check matrix with a code rate of 1/2 is generated by the generation unit 332, using the parity check matrix with the code rate of 4/5 to add three rows.

In the check matrix generation device 330, the generation unit 332 adds the rows of the parity check matrices. In the first embodiment, the check matrix generation device 330 prestores the parity check matrix with the code rate of 4/5, which is the highest code rate conceivable in the communication system 400 illustrated in FIG. 1, in the storage unit 331. The parity check matrix with the highest code rate is composed of P×P submatrices, where P is a common divisor of a row count m and a column count n of the parity check matrix. It is to be noted that P is also a positive integer. For example, the parity check matrix with the code rate of 4/5 illustrated in FIG. 1 is composed of P×P submatrices forming two blocks of row components and ten blocks of column components. The parity check matrix with the highest code rate stored in the storage unit 331 may be referred to as the first check matrix when described below. In other words, the storage unit 331 stores the first parity check matrix with the highest code rate that can be divided into the blocks of P×P submatrices and is conceivable as the check matrix of the low-density parity-check code used in communication.

The generated parity check matrices where the rows have been added by the generation unit 332 may be referred to as the second check matrices.

Each of the P×P submatrices is a zero matrix where all elements are zero-valued, an identity matrix, or a cyclic permutation matrix obtained by cyclically right shifting 1s in the identity matrix by i positions. It is to be noted that 0≤i≤P-1. In the middle and bottom parity check matrices of FIG. 2, portions denoted by 0s are zero matrices, and portions with denotations such as S(A1), S(B2), and T(A1) are cyclic permutation matrices.

A description is provided first of the generation of the parity check matrix with the code rate of 3/5 illustrated in the middle part of FIG. 2 by the generation unit 332. In a procedure for adding the rows of the parity check matrix, the generation unit 332 generates a first row block of the parity check matrix by setting some portions of the row component to zero matrices and keeping the other portions the same as in the first row block of the parity check matrix for the code with the code rate of 4/5 stored in the storage unit 331.

Next, for a second row block, the generation unit 332 sets some portions of the row component to zero matrices relative to the first row block of the parity check matrix of the code with the code rate of 4/5. At this time, the generation unit 332 ensures that the zero matrices are not set in portions corresponding to the zero matrices in the first row block. Furthermore, for the portions where no zero matrices are to be set, the generation unit 332 generates matrices where corresponding 1s from the parity check matrix with the code rate of 4/5 are cyclically shifted by a fixed value, thus generating the second row block of the parity check matrix.

The generation unit 332 generates a third row block of the parity check matrix by setting some portions of the row component to zero matrices and keeping the other portions the same as in the second row block of the parity check matrix for the code with the code rate of 4/5.

Next, for a fourth row block, the generation unit 332 sets some portions of the row component to zero matrices relative to the second row block of the parity check matrix of the code with the code rate of 4/5. At this time, the generation unit 332 ensures that the zero matrices are not set in portions corresponding to the zero matrices in the third row block. Furthermore, for the portions where no zero matrices are to be set, the generation unit 332 generates matrices where corresponding 1s from the parity check matrix with the code rate of 4/5 are cyclically shifted by the fixed value, thus generating the fourth row block of the parity check matrix.

The generation unit 332 extends the rows as above thus, allowing for the generation of the parity check matrix with the code rate of 3/5 that is composed of the P×P submatrices forming four blocks of row components and ten blocks of column components.

A description is provided also of the generation of the parity check matrix with the code rate of 1/2 illustrated in the bottom part of FIG. 2 by the generation unit 332. In a procedure for adding the rows of the parity check matrix, the generation unit 332 generates a first row block of the parity check matrix by setting some portions of the row component to zero matrices and keeping the other portions the same as in the first row block of the parity check matrix for the code with the code rate of 4/5 stored in the storage unit 331.

Next, for a second row block, the generation unit 332 sets some portions of the row component to zero matrices relative to the first row block of the parity check matrix of the code with the code rate of 4/5. Furthermore, for portions where no zero matrices are to be set, the generation unit 332 generates matrices where corresponding 1s from the parity check matrix with the code rate of 4/5 are cyclically shifted by the fixed value, thus generating the second row block of the parity check matrix.

Next, for a third row block, the generation unit 332 sets some portions of the row component to zero matrices relative to the first row block of the parity check matrix of the code with the code rate of 4/5. At this time, the generation unit 332 ensures that the zero matrices are not set in portions corresponding to the zero matrices in the second row block. Furthermore, for the portions where no zero matrices are to be set, the generation unit 332 generates matrices where corresponding 1s from the parity check matrix with the code rate of 4/5 are cyclically shifted by a fixed value differing from when generating the second row block, thus generating the third row block of the parity check matrix.

The generation unit 332 generates a fourth row block of the parity check matrix by setting some portions of the row component to zero matrices and keeping the other portions the same as in the second row block of the parity check matrix for the code with the code rate of 4/5.

Next, for a fifth row block, the generation unit 332 sets some portions of the row component to zero matrices relative to the second row block of the parity check matrix of the code with the code rate of 4/5. At this time, the generation unit 332 ensures that the zero matrices are not set in portions corresponding to the zero matrices in the fourth row block. Furthermore, for the portions where no zero matrices are to be set, the generation unit 332 generates matrices where corresponding 1s from the parity check matrix with the code rate of 4/5 are cyclically shifted by the fixed value, thus generating the fifth row block of the parity check matrix.

The generation unit 332 extends the rows as above thus, allowing for the generation of the parity check matrix with the code rate of 1/2 that is composed of the P×P submatrices forming five blocks of row components and ten blocks of column components.

The generation unit 332 is also capable of generating parity check matrices of codes with other code rates, using the same method. Using the method described above, the generation unit 332 is capable of varying the code rate while keeping code length constant for the parity check matrices to be used by the decoding unit 340. In the above-described examples, the generation unit 332 performs the row-specific cyclical shifting by the fixed value to generate the parity check matrices; however, the generation unit 332 may change the shift amount for each column component.

The generation unit 332 may set some blocks of the row block of the original parity check matrix to zero matrices and shift the other blocks by the fixed amount in effecting each of plural row extensions, thus lowering the code rate. Since this does not lead to a decreased row weight and a decreased column weight compared to the row weight and the column weight of the original LDPC code, the generation unit 332 enables restrained degradation of code performance.

The generation unit 332 may store the generated parity check matrices with the code rates of 3/5, 1/2, and others in the storage unit 331. Therefore, even when the communication apparatus 100 changes the code rate for encoding according to circumstances of the communication channel 200, by having the previously generated parity check matrices stored, the generation unit 332 allows for reduced computational processing compared to when the parity check matrix is generated each time the code rate changes.

In the communication system 400, if the code rate of the parity check matrix used by the communication apparatus 100 in encoding is known to the communication apparatus 300, the communication apparatus 300 can efficiently decode a transmitted signal from the communication apparatus 100. In the communication system 400, the communication apparatuses 100 and 300 operate according to common rules, such as the method illustrated in the middle part of FIG. 2 for adding the two rows of the parity check matrix and the method illustrated in the bottom part of FIG. 2 for adding the three rows of the parity check matrix. In this case, the communication apparatus 100 may provide the communication apparatus 300 with information on the code rate of the parity check matrix used in the communication system 400, or a higher-level device (not illustrated) may inform the communication apparatuses 100 and 300 of the code rate of the parity check matrix to be used.

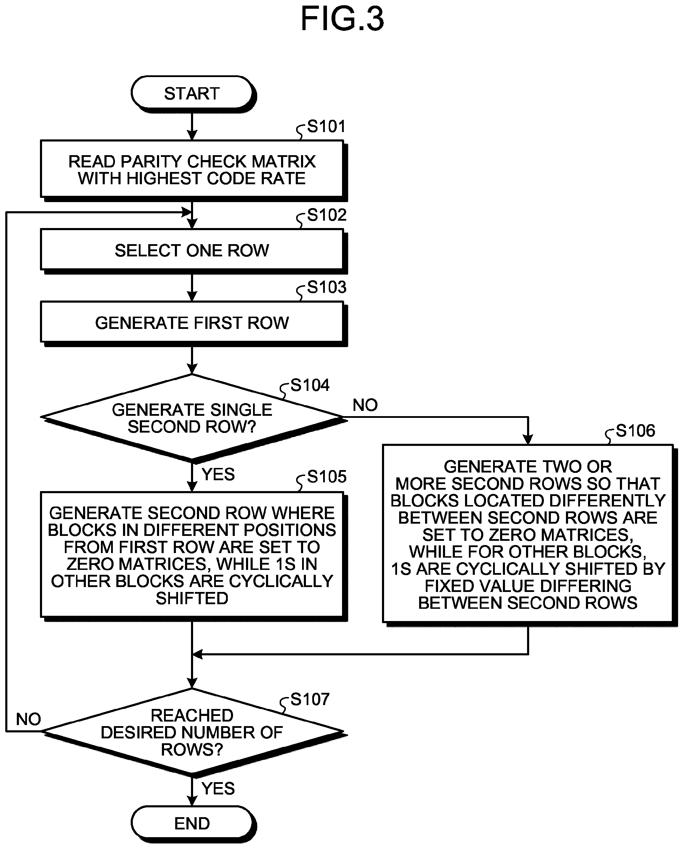

FIG. 3 is a flowchart illustrating how the check matrix generation device 330 according to the first embodiment operates. The generation unit 332 of the check matrix generation device 330 reads from the storage unit 331 the parity check matrix that can be divided into the blocks of P×P submatrices and has the highest code rate conceivable in the communication system 400 (step S101). The generation unit 332 selects one row from the read parity check matrix (step S102). Using the selected row, the generation unit 332 generates a first row by setting some blocks of the row component to zero matrices and the other blocks the same as in the original row component (step S103). The first row corresponds to any of the first and third rows of the parity check matrix with the code rate of 3/5 illustrated in the middle part of FIG. 2 and the first and fourth rows of the parity check matrix with the code rate of 1/2 illustrated in the bottom part of FIG. 2, among others.

If the generation unit 332 generates a single second row, using the selected row (step S104: Yes), the generation unit 332 sets blocks (portions of the row component) located differently from the first row's blocks that have been set to the zero matrices to zero matrices and for the other blocks, cyclically shifts 1s by a specified fixed value, thus generating the second row (step S105). The second row generated at step S105 corresponds to any of the second and fourth rows of the parity check matrix with the code rate of 3/5 illustrated in the middle part of FIG. 2 and the fifth row of the parity check matrix with the code rate of 1/2 illustrated in the bottom part of FIG. 2, among others.

If, on the other hand, the generation unit 332 generates two or more second rows, using the selected row (step S104: No), the generation unit 332 sets blocks (portions of the row component) that are located differently between the second rows to zero matrices and for the other blocks, cyclically shifts 1s by a specified fixed value that differs between the second rows, thus generating the two or more second rows (step S106). The second rows generated at step S106 correspond to the second and third rows of the parity check matrix with the code rate of 1/2 illustrated in the bottom part of FIG. 2, among others.

If the generation unit 332 has not reached a desired number of rows for the parity check matrix to be generated (step S107: No), the generation unit 332 returns to step S102 and selects one unselected row from the read parity check matrix. If the generation unit 332 has reached the desired number of rows for the parity check matrix to be generated (step S107: Yes), the generation unit 332 ends the operation.

As described above, the generation unit 332 generates, using the first check matrix's unit row including submatrices in column directions, the first row where some blocks are replaced with the zero matrices and the at least one second row where the specified blocks are replaced with the zero matrices, with the other blocks of submatrices having 1s shifted by the specified fixed value, to generate the second check matrix with the lower code rate than the first check matrix. When the generation unit 332 generates one second row, the generation unit 332 replaces the blocks not replaced with zero matrices in the first row with the zero matrices as the specified blocks. When, on the other hand, the generation unit 332 generates at least two second rows, the generation unit 332 replaces the blocks differing between the at least two second rows with the zero matrices as the specified blocks, and makes the fixed value differ between the at least two second rows. The generation unit 332 uses the first check matrix's plural unit rows that each include the submatrices in the column directions and generates the first row and the at least one second row for each of the plural unit rows.

A description is provided next of a hardware configuration of the communication apparatus 300. The reception unit 310 of the communication apparatus 300 is a communication device. The decoding device 320 is implemented with processing circuitry. The processing circuitry may include a memory and a processor that executes programs stored in the memory or may be dedicated hardware. The processing circuitry is also referred to as control circuit.

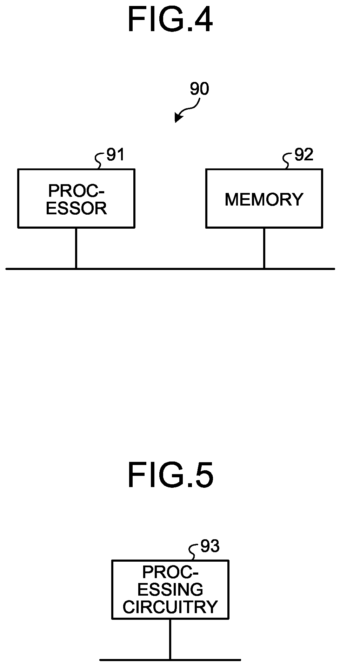

FIG. 4 is a diagram illustrating an exemplary configuration of processing circuitry 90 configured with a processor 91 and a memory 92 as processing circuitry that implements the communication apparatus 300 according to the first embodiment. The processing circuitry 90 illustrated in FIG. 4 is a control circuit and includes the processor 91 and the memory 92. For the processing circuitry 90 that includes the processor 91 and the memory 92, the functions of the processing circuitry 90 are implemented with software, firmware, or a combination of software and firmware. The software or the firmware is described as programs and is stored in the memory 92. In the processing circuitry 90, the processor 91 reads and executes the programs stored in the memory 92 to implement the functions. This means that the memory 92 is included in the processing circuitry 90 to store the programs that result in the execution of the operations of the communication apparatus 300. These programs can be said to be programs that cause the functions that the processing circuitry 90 implements to be performed by the communication apparatus 300. These programs may be stored in a storage medium and provided or may be provided by other means, such as a communication medium.

When the decoding device 320 includes the storage unit 331 storing the first check matrix with the highest code rate that can be divided into the blocks of P×P submatrices, the highest code rate being conceivable as the check matrix of the low-density parity-check code used in communication, the above programs can also be said to cause the communication apparatus 300 to perform a first step of generating, with the generation unit 332, the first row where some blocks are replaced with the zero matrices by use of the first check matrix's unit row including the submatrices in the column directions; and a second step of further generating, with the generation unit 332, the at least one second row where the specified blocks are replaced with the zero matrices, with the other blocks of submatrices having 1s shifted by the specified fixed value, by use of the first check matrix's unit row including the submatrices in the column directions, to generate the second check matrix with the lower code rate than the first check matrix.

Examples of the processor 91 herein include a central processing unit (CPU), a processing unit, an arithmetic unit, a microprocessor, a microcomputer, and a digital signal processor (DSP), among others. Examples that each correspond to the memory 92 include nonvolatile and volatile semiconductor memories, such as a random access memory (RAM), a read only memory (ROM), a flash memory, an erasable programmable ROM (EPROM), and an electrically EPROM (EEPROM) (registered trademark), a magnetic disk, a flexible disk, an optical disk, a compact disk, a mini disk, and a digital versatile disc (DVD), among others.

FIG. 5 is a diagram illustrating an example of processing circuitry 93 configured as dedicated hardware to serve as the processing circuitry that implements the communication apparatus 300 according to the first embodiment. Examples that each correspond to the processing circuitry 93 illustrated in FIG. 5 include a single circuit, a composite circuit, a programmed processor, a parallel programmed processor, an application specific integrated circuit (ASIC), a field programmable gate array (FPGA), and combinations of these. The processing circuitry may be realized partly by dedicated hardware and partly by software or firmware. By including the dedicated hardware, the software, the firmware, or a combination of these, the processing circuitry is capable of implementing the above functions.

The described hardware configuration of the communication apparatus 300 is similar to a hardware configuration of the communication apparatus 100. The transmission unit 140 of the communication apparatus 100 is a communication device. The encoding device 110 is implemented with processing circuitry. The processing circuitry may include a memory and a processor that executes programs stored in the memory or may be dedicated hardware.

According to the present embodiment described above, using the unit row with the submatrices in the column directions that is included in the first check matrix with the highest code rate that can be divided into the blocks of P×P submatrices, the highest code rate being conceivable as the check matrix of the LDPC code used in communication, each of the generation units 122 and 332 of the check matrix generation devices 120 and 330 generates the first row where some blocks are replaced with the zero matrices. Using the first check matrix's unit row with the submatrices in the column directions, each of the generation units 122 and 332 of the check matrix generation devices 120 and 330 further generates the at least one second row where the specified blocks are replaced with the zero matrices, with the other blocks of submatrices having 1s shifted by the specified fixed value, to generate the second check matrix with the lower code rate than the first check matrix. Consequently, the encoding device 110 including the check matrix generation device 120 and the decoding device 320 including the check matrix generation device 330 each allow for restrained degradation of code performance when the check matrix has increased rows.

### Second Embodiment.

In the communication system 400 illustrated in FIG. 1, the decoding device 320 of the communication apparatus 300 decodes the signal encoded by the communication apparatus 100 and received over the communication channel 200 from the communication apparatus 100. In the decoding device 320, the decoding unit 340 obtains the parity check matrix from the check matrix generation device 330 and repeatedly performs a row operation processing and a column operation processing to generate a decoding result. In a second embodiment, a description is provided of the row operation processing that is performed by the decoding unit 340 of the decoding device 320.

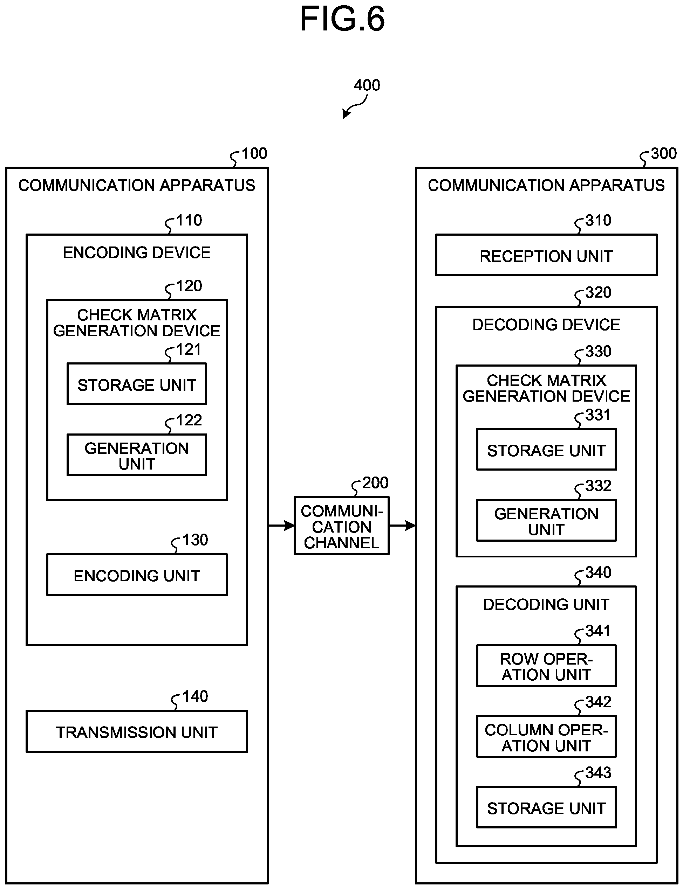

FIG. 6 is a diagram illustrating an exemplary configuration of the communication system 400 including the communication apparatuses 100 and 300 according to the second embodiment. FIG. 6 illustrates the communication system 400 of the second embodiment, detailing a configuration of the decoding unit 340 of the communication apparatus 300, in contrast to FIG. 1, which illustrates the communication system 400 of the first embodiment. The decoding unit 340 performs decoding by repeatedly performing the row operation processing and the column operation processing by use of the first check matrix or the second check matrix. As illustrated in FIG. 6, the decoding unit 340 includes a row operation unit 341, a column operation unit 342, and a storage unit 343.

The row operation unit 341 performs the row operation processing, which is repeated by the decoding unit 340. A description of a detailed configuration and operation of the row operation unit 341 is provided later. The column operation unit 342 performs the column operation processing, which is repeated by the decoding unit 340. A description of a detailed configuration and operation of the column operation unit 342 is provided in a third embodiment. The storage unit 343 stores operation results halfway through the repetitious row operation processing of the row operation unit 341 and operation results halfway through the repetitious column operation processing of the column operation unit 342, among others. The storage unit 343 of the decoding device 320 is configured as a single storage unit in the example of FIG. 6; however, the storage unit 343 may be composed of plural storage units. The storage unit 343 and the storage unit 331 of the check matrix generation device 330 may be configured as a single storage unit.

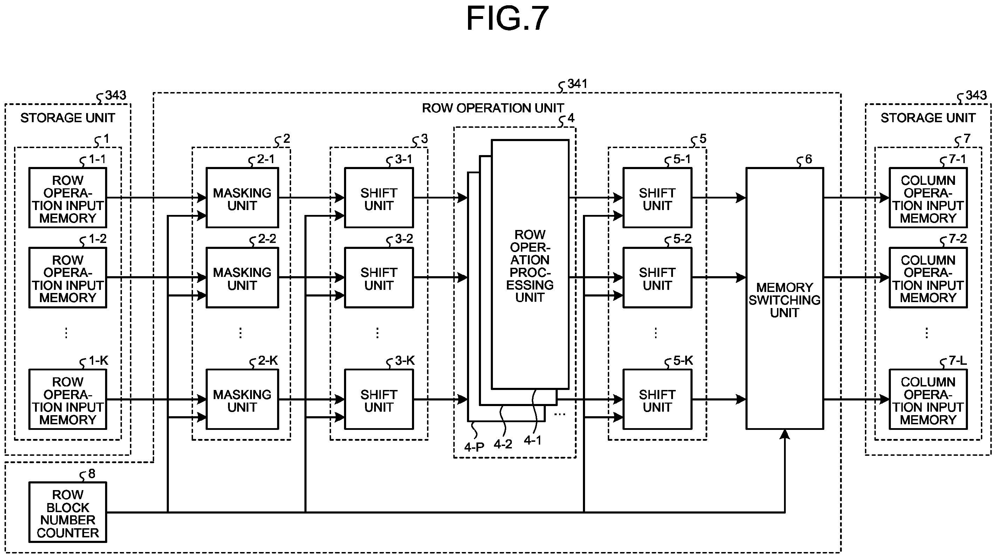

The description of the detailed configuration and the operation of the row operation unit 341 is as follows. FIG. 7 is a diagram illustrating the exemplary configuration of the row operation unit 341 included in the decoding unit 340 according to the second embodiment. The row operation unit 341 includes masking units 2 including masking units 2-1 to 2-K; shift units 3 including shift units 3-1 to 3-K; row operation processing units 4 including row operation processing units 4-1 to 4-P; shift units 5 including shift units 5-1 to 5-K; a memory switching unit 6; and a row block number counter 8. FIG. 7 also illustrates some parts of the storage unit 343 included in the decoding unit 340. The storage unit 343 includes row operation input memories 1 including row operation input memories 1-1 to 1-K, and column operation input memories 7 including column operation input memories 7-1 to 7-L. In FIG. 7, K represents a P×P submatrix count per row block of the parity check matrix. With N being code length, K=N/P. It is to be noted that K, N, and P are positive integers.

The operation of the row operation unit 341 is described next. First, the reception unit 310 of the communication apparatus 300 performs the demodulation or the like on the signal received over the communication channel 200 from the communication apparatus 100 and outputs received soft decision data to the decoding device 320. In the storage unit 343, the K row operation input memories 1-1 to 1-K, which are arranged in parallel, store the received soft decision data as initial values. Specifically, the received soft decision data are divided into P words and written to the row operation input memories 1-1 to 1-K, with each P word for one address.

The masking units 2-1 to 2-K of the row operation unit 341 simultaneously read data written to the row operation input memories 1-1 to 1-K in blocks. In other words, the masking units 2 simultaneously read the K blocks of data written to the row operation input memories 1. The masking units 2 perform masking on the blocks corresponding to the zero matrices in the parity check matrix. The masking units 2 output the blocks that correspond to the shifted identity matrices, not the zero matrices, in the parity check matrix without performing any particular operation.

The shift units 3 perform shifting on the blocks that correspond to the shifted identity matrices, not the zero matrices, in the parity check matrix, specifically shifting back the blocks that have undergone no operation in the masking units 2 by an amount equivalent to the shift amount by which the identity matrices have been shifted. As described above, the received soft decision data written to the row operation input memories 1-1 to 1-K undergo the masking by the masking units 2 or the shifting by the shift units 3 and are then input to the row operation processing units 4.

The operation of the masking units 2 and the operation of the shift units 3 are controlled by the row block number counter 8 on the basis of a row block number being processed. The row block number counter 8 counts row block numbers to be processed. The row block number counter 8 controls the operation of the masking units 2, the operation of the shift units 3, operation of the shift units 5, and operation of the memory switching unit 6 on the basis of a counted value, namely the row block number. The method described in the first embodiment or the like is assumed to have been used for the row block number counter 8 to obtain the information on the parity check matrix's code rate being used in the communication apparatuses 100 and 300.

The row operation processing units 4 divide the data not masked by the masking units 2 among the data output from the shift units 3 into P portions. The data divided into the P portions are input to the corresponding row operation processing units 4-1 to 4-P. The row operation processing units 4-1 to 4-P perform the row operation processing on the S data inputs other than those masked by the masking units 2 among the K data outputs from the shift units 3 to generate and output S data. It is to be noted that S is a positive integer less than or equal to K. When performing the row operation processing using, for example, a min-sum algorithm, the row operation processing units 4, namely the row operation processing units 4-1 to 4-P, generate and output S values, each obtained by combining a minimum absolute value and the product of positive and negative signs for (S-1) data excluding one. The row operation processing units 4 combine the S data from the row operation processing units 4-1 to 4-P, which operate in parallel, in units of data stored in the row operation input memories 1-1 to 1-K, or in block units, and output the K data after the row operation processing.

The shift units 5 perform reverse shifting on the data output from the row operation processing units 4, shifting in an opposite direction to the shifting performed by the shift units 3. The shift units 5 do not perform the reverse shifting on those not shifted by the shift units 3.

The memory switching unit 6 stores the data reverse shifted or the data not reverse shifted by the shift units 5 in corresponding addresses of the column operation input memories 7.

The operation of the shift units 5 and the operation of the memory switching unit 6 are also controlled by the row block number counter 8 on the basis of the row block number being processed. The row block number counter 8 specifies memory numbers and the addresses of the L column operation input memories 7-1 to 7-L in parallel arrangement for the memory switching unit 6 to write the data.

The data written to the column operation input memories 7-1 to 7-L have undergone the row operation processing in the row operation unit 341 and are used in the column operation (described later) of the column operation unit 342.

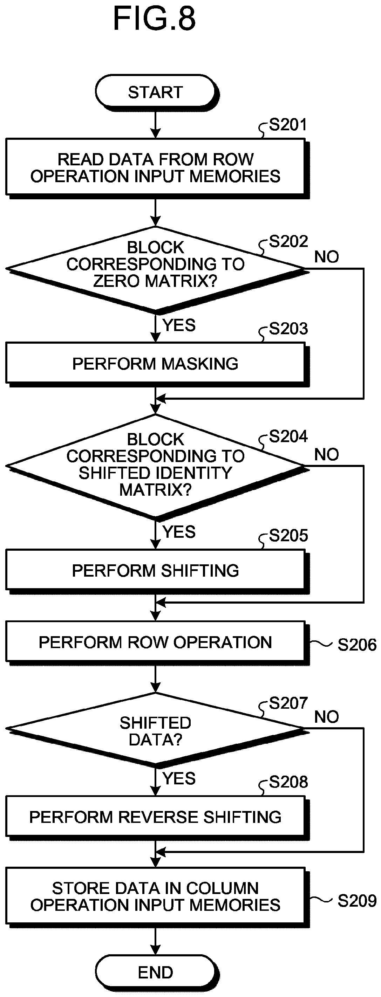

FIG. 8 is a flowchart illustrating how the row operation unit 341 of the decoding unit 340 according to the second embodiment performs the row operation. The masking units 2 of the row operation unit 341 read the data from the row operation input memories 1 of the storage unit 343 (step S201). Each of the masking units 2 performs the masking (step S203) if the block corresponds to the zero matrix (step S202: Yes) and outputs the block to the shift unit 3. Each masking unit 2 outputs the block to the shift unit 3 without performing the masking if the block does not correspond to the zero matrix (step S202: No). Each shift unit 3 performs the shifting that shifts back the block by the amount equivalent to the shift amount (step S205) if the data obtained from the masking unit 2 is the block corresponding to the shifted identity matrix (step S204: Yes) and outputs the block to the row operation processing units 4. Each shift unit 3 outputs the block to the row operation processing units 4 without performing the shifting if the data is not the block corresponding to the shifted identity matrix (step S204: No).

The row operation processing units 4 perform the row operation processing using the data obtained from the shift units 3 (step S206) and output the results of the row operation processing to the shift units 5. Each shift unit 5 performs the reverse shifting, the shifting in the opposite direction to that performed by the shift unit 3 (step S208), if the data obtained from the row operation processing units 4 corresponds to the data shifted by the shift unit 3 (step S207: Yes) and outputs the data to the memory switching unit 6. Each shift unit 5 outputs the data to the memory switching unit 6 without performing the reverse shifting if the data does not correspond to the data shifted by the shift unit 3 (step S207: No). The memory switching unit 6 stores the data obtained from the shift units 5 in the column operation input memories 7 on the basis of instructions from the row block number counter 8 (step S209).

According to the present embodiment described above, the row operation unit 341 in the decoding unit 340 of the decoding device 320 performs, in the row operation to be repeated, the masking and the shifting that are specific to the positions in the parity check matrix where the zero matrices are disposed and therefore, can easily perform the row operation even for the plural LDPC codes with the code rates extended by the method described in the first embodiment. In the row operation processing, the row operation unit 341 performs the masking on the blocks of submatrices replaced with the zero matrices and the shifting that shifts back the blocks of submatrices shifted by the fixed value. Therefore, even when the check matrix with the different code rate is used, the row operation unit 341 can perform the same row operation processing as performed for the first check matrix.

### Third Embodiment.

In the communication system 400 illustrated in FIG. 1, the decoding device 320 of the communication apparatus 300 decodes the signal encoded by the communication apparatus 100 and received over the communication channel 200 from the communication apparatus 100. In the decoding device 320, the decoding unit 340 obtains the parity check matrix from the check matrix generation device 330 and repeatedly performs the row operation processing and the column operation processing to generate the decoding result. In the third embodiment, a description is provided of the column operation processing that is performed by the decoding unit 340 of the decoding device 320.

In the third embodiment, the communication system 400 including the communication apparatuses 100 and 300 has the same configuration as the second embodiment's communication system 400 with the communication apparatuses 100 and 300 illustrated in FIG. 6.

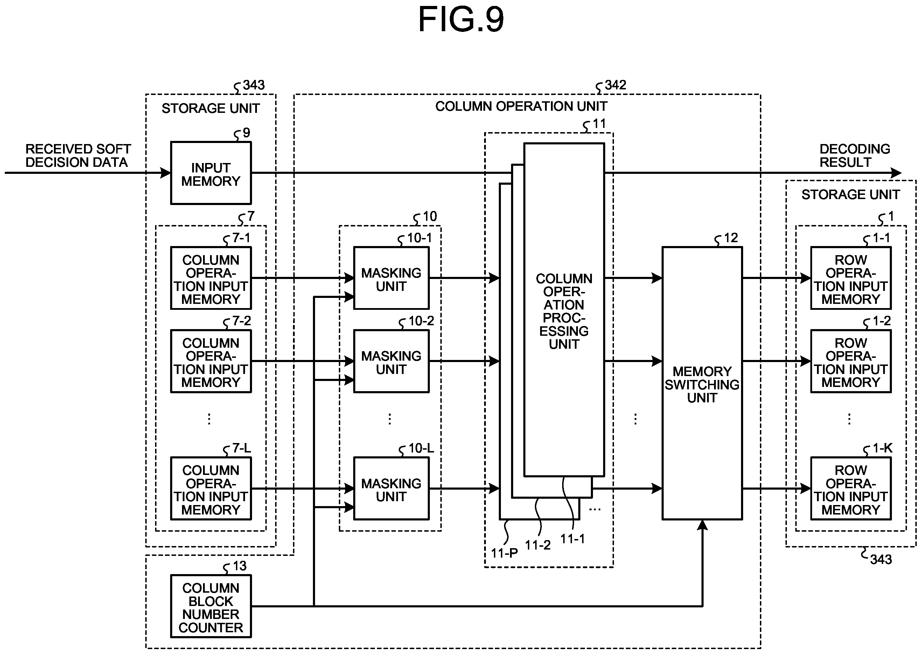

The description of the detailed configuration and the operation of the column operation unit 342 is as follows. FIG. 9 is a diagram illustrating the exemplary configuration of the column operation unit 342 included in the decoding unit 340 according to the third embodiment. The column operation unit 342 includes masking units 10 including masking units 10-1 to 10-L; column operation processing units 11 including column operation processing units 11-1 to 11-P; a memory switching unit 12; and a column block number counter 13. FIG. 9 also illustrates some parts of the storage unit 343 included in the decoding unit 340. The storage unit 343 includes the row operation input memories 1, which include the row operation input memories 1-1 to 1-K, the column operation input memories 7, which include the column operation input memories 7-1 to 7-L, and an input memory 9. In FIG. 9, L represents a P×P submatrix count per column block of the parity check matrix. With N being the code length and J being information bit length, L=(N-J)/P. It is to be noted that J, L, N, and P are positive integers.

The operation of the column operation unit 342 is described next. First, the reception unit 310 of the communication apparatus 300 performs the demodulation or the like on the signal received over the communication channel 200 from the communication apparatus 100 and outputs the received soft decision data to the decoding device 320. The input memory 9 of the storage unit 343 stores the received soft decision data. Specifically, the received soft decision data are written to the input memory 9, with each P word for one address. At a point in time when the received soft decision data are input to the input memory 9, no values are input to the L column operation input memories 7-1 to 7-L, which are arranged in parallel. However, the row operation unit 341 described in the second embodiment writes the results of the row operation processing to the column operation input memories 7-1 to 7-**L.**

The column operation unit 342 simultaneously reads data written to the input memory 9 and data written to the L column operation input memories 7-1 to 7-L, which are arranged in parallel. The masking units 10-1 to 10-L of the column operation unit 342 simultaneously read the data written to the column operation input memories 7-1 to 7-L in blocks. In other words, the masking units 10 simultaneously read the L blocks of data written to the column operation input memories 7. The masking units 10 perform masking on the blocks corresponding to the zero matrices in the parity check matrix. The masking units 10 output the blocks that correspond to the shifted identity matrices, not the zero matrices, in the parity check matrix without performing any particular operation.

The operation of the masking units 10 is controlled by the column block number counter 13 on the basis of a column block number being processed. The column block number counter 13 counts column block numbers to be processed. The column block number counter 13 controls the operation of the masking units 10 and operation of the memory switching unit 12 on the basis of a counted value, namely the column block number. The method described in the first embodiment or the like is assumed to have been used for the column block number counter 13 to obtain the information on the parity check matrix's code rate being used in the communication apparatuses 100 and 300.

The column operation processing units 11 divide each of the received soft decision data read from the input memory 9 and the data not masked by the masking units 10 into P portions. The data divided into the P portions are input to the corresponding column operation processing units 11-1 to 11-P. The column operation processing units 11-1 to 11-P perform the column operation processing on the T data inputs other than those masked by the masking units 10 among the L data outputs from the masking units 10 to generate and output T data. It is to be noted that T is a positive integer less than or equal to **L.** In the column operation processing, the column operation processing units 11 generate and output T values, each obtained by adding (T-1) data, which are the T data inputs minus one, and a value of the received soft decision data from the input memory 9.

After a prespecified number of iterations of the column operation, the column operation processing units 11 use sign bits of the values obtained by the addition of the T data inputs from the masking units 10 and the values of the received soft decision data as decoding results and combine these sign bits with P data from the column operation processing units 11-1 to 11-P, which operate in parallel, thus outputting P-bit data as a decoding result.

When the column operation processing units 11 have not performed the column operation for the prespecified number of iterations, the column operation processing units 11 combine the T data from the column operation processing units 11-1 to 11-P, which operate in parallel, in units of data stored in the column operation input memories 7-1 to 7-L, or in block units, and output the K data after the column operation processing.

The memory switching unit 12 stores the data output from the column operation processing units 11 in corresponding addresses of the row operation input memories 1.

The operation of the memory switching unit 12 is also controlled by the column block number counter 13 on the basis of the column block number being processed. The column block number counter 13 specifies memory numbers and the addresses of the K row operation input memories 1-1 to 1-K in parallel arrangement for the memory switching unit 12 to write the data.

The data written to the row operation input memories 1-1 to 1-K have undergone the column operation processing in the column operation unit 342 and are used in the above-described row operation of the row operation unit 341.

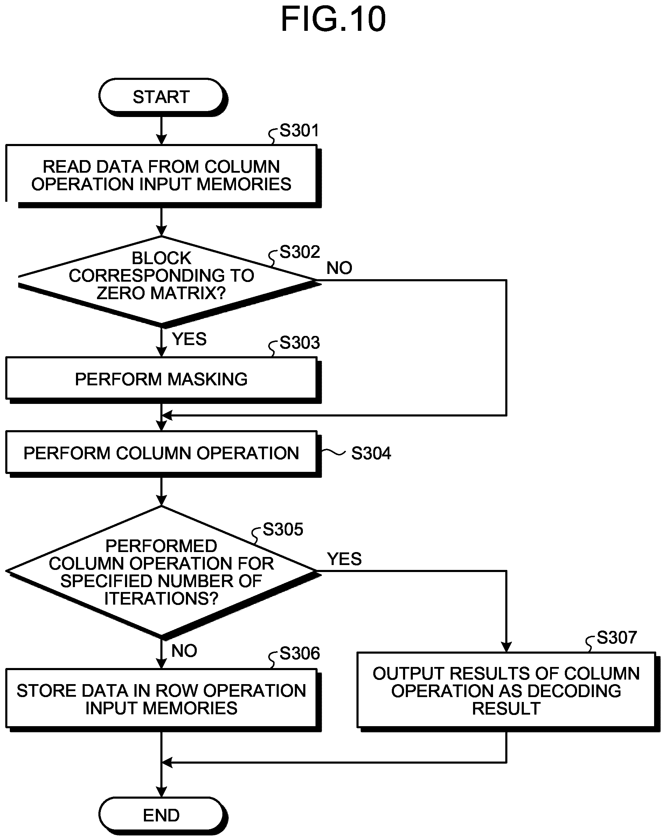

FIG. 10 is a flowchart illustrating how the column operation unit 342 of the decoding unit 340 according to the third embodiment performs the column operation. The masking units 10 of the column operation unit 342 read the data from the column operation input memories 7 of the storage unit 343 (step S301). Each of the masking units 10 performs the masking (step S303) if the block corresponds to the zero matrix (step S302: Yes) and outputs the block to the column operation processing units 11. The column operation processing units 11 perform the column operation processing using the data obtained from the input memory 9 and the masking units 10 (step S304). If the column operation processing units 11 have not performed the column operation processing for the specified number of iterations (step S305: No), the column operation processing units 11 output the results of the column operation processing to the memory switching unit 12. The memory switching unit 12 stores the data obtained from the column operation processing units 11 in the row operation input memories 1 on the basis of instructions from the column block number counter 13 (step S306). If the column operation processing units 11 have performed the column operation processing for the specified number of iterations (step S305: Yes), the column operation processing units 11 output the results of the column operation processing as the decoding result (step S307).

According to the present embodiment described above, the column operation unit 342 in the decoding unit 340 of the decoding device 320 performs, in the column operation to be repeated, the masking specific to the positions in the parity check matrix where the zero matrices are disposed and therefore, can easily perform the column operation even for the plural LDPC codes with the code rates extended by the method described in the first embodiment. In the column operation processing, the column operation unit 342 performs the masking on the blocks of submatrices replaced with the zero matrices. Therefore, even when the check matrix with the different code rate is used, the column operation unit 342 can perform the same column operation processing as performed for the second check matrix with the lowest code rate.

The above configurations illustrated in the embodiments are illustrative, can be combined with other techniques that are publicly known, and can be partly omitted or changed without departing from the gist. The embodiments can be combined with each other.

### Reference Signs List

1, 1-1 to 1-K row operation input memory; 2, 2-1 to 2-K, 10, 10-1 to 10-L masking unit; 3, 3-1 to 3-K, 5, 5-1 to 5-K shift unit; 4, 4-1 to 4-P row operation processing unit; 6, 12 memory switching unit; 7, 7-1 to 7-L column operation input memory; 8 row block number counter; 9 input memory; 11, 11-1 to 11-P column operation processing unit; 13 column block number counter; 100, 300 communication apparatus; 110 encoding device; 120, 330 check matrix generation device; 121, 331, 343 storage unit; 122, 332 generation unit; 130 encoding unit; 140 transmission unit; 200 communication channel; 310 reception unit; 320 decoding device; 340 decoding unit; 341 row operation unit; 342 column operation unit; 400 communication system.

## Claims

1. A decoding device comprising:
a storage unit to store a first check matrix with a highest code rate that can be divided into blocks of P×P submatrices, the highest code rate being conceivable as a check matrix of a low-density parity-check code used in communication, where
P is a positive integer; and
a generation unit to generate, using a unit row of the first check matrix that includes the submatrices in column directions, a first row where some blocks are replaced with zero matrices and at least one second row where specified blocks are replaced with zero matrices, with other blocks of submatrices having 1s shifted by a specified fixed value, to generate a second check matrix with a lower code rate than the first check matrix.

2. The decoding device according to claim 1, wherein
when the generation unit generates the at least one second row that is a single second row, the generation unit replaces blocks not replaced with zero matrices in the first row with zero matrices as the specified blocks.

3. The decoding device according to claim 1, wherein
when the generation unit generates the at least one second row that is at least two second rows, the generation unit replaces blocks that differ between the at least two second rows with zero matrices as the specified blocks, and makes the fixed value differ between the at least two second rows.

4. The decoding device according to any one of claims 1 to 3, wherein
the generation unit uses a plurality of unit rows of the first check matrix that each include the submatrices in column directions and generates the first row and the at least one second row for each of the unit rows.

5. The decoding device according to any one of claims 1 to 4, comprising
a decoding unit to repeatedly perform a row operation processing and a column operation processing in decoding using one of the first check matrix and the second check matrix.

6. The decoding device according to claim 5, wherein
the decoding unit includes
a row operation unit to perform, in the row operation processing, masking on blocks of submatrices replaced with the zero matrices and shifting that shifts back blocks of submatrices shifted by the fixed value, to perform same operation as a row operation processing performed for the first check matrix even when a check matrix with a different code rate is used.

7. The decoding device according to claim 5 or 6, wherein
the decoding unit includes
a column operation unit to perform, in the column operation processing, masking on blocks of submatrices replaced with the zero matrices, to perform same operation as a column operation processing performed for the second check matrix with the code rate that is lowest even when a check matrix with a different code rate is used.

8. A control circuit to control a decoding device, the decoding device comprising
a storage unit to store a first check matrix with a highest code rate that can be divided into blocks of P×P submatrices, the highest code rate being conceivable as a check matrix of a low-density parity-check code used in communication, where
P is a positive integer, wherein
the control circuit configured to cause the decoding device to:
generate a first row where some blocks are replaced with zero matrices by use of a unit row of the first check matrix that includes the submatrices in column directions; and
further generate at least one second row where specified blocks are replaced with zero matrices, with other blocks of submatrices having 1s shifted by a specified fixed value, by use of a unit row of the first check matrix that includes the submatrices in column directions, to generate a second check matrix with a lower code rate than the first check matrix.

9. A storage medium storing a program to control a decoding device, the decoding device comprising
a storage unit to store a first check matrix with a highest code rate that can be divided into blocks of P×P submatrices, the highest code rate being conceivable as a check matrix of a low-density parity-check code used in communication, where
P is a positive integer, wherein
the program causes the decoding device to:
generate a first row where some blocks are replaced with zero matrices by use of a unit row of the first check matrix that includes the submatrices in column directions; and
further generate at least one second row where specified blocks are replaced with zero matrices, with other blocks of submatrices having 1s shifted by a specified fixed value, by use of a unit row of the first check matrix that includes the submatrices in column directions, to generate a second check matrix with a lower code rate than the first check matrix.

10. A check matrix generation method for a decoding device, the decoding device comprising
a storage unit to store a first check matrix with a highest code rate that can be divided into blocks of P×P submatrices, the highest code rate being conceivable as a check matrix of a low-density parity-check code used in communication, where
P is a positive integer, wherein
the check matrix generation method comprising:
a first step of generating, by a generation unit, a first row where some blocks are replaced with zero matrices by use of a unit row of the first check matrix that includes the submatrices in column directions; and
a second step of further generating, by the generation unit, at least one second row where specified blocks are replaced with zero matrices, with other blocks of submatrices having 1s shifted by a specified fixed value, by use of a unit row of the first check matrix that includes the submatrices in column directions, to generate a second check matrix with a lower code rate than the first check matrix.

11. The check matrix generation method according to claim 10, wherein
when the generation unit generates the at least one second row that is a single second row in the second step, the generation unit replaces blocks not replaced with zero matrices in the first row with zero matrices as the specified blocks.

12. The check matrix generation method according to claim 10, wherein
when the generation unit generates the at least one second row that is at least two second rows in the second step, the generation unit replaces blocks that differ between the at least two second rows with zero matrices as the specified blocks, and makes the fixed value differ between the at least two second rows.

13. The check matrix generation method according to any one of claims 10 to 12, wherein
in the first step, the generation unit uses a plurality of unit rows of the first check matrix that each include the submatrices in column directions and generates the first row for each of the unit rows, and
in the second step, the generation unit uses a plurality of unit rows of the first check matrix that each include the submatrices in column directions and generates the at least one second row for each of the unit rows.

14. The check matrix generation method according to any one of claims 10 to 13, further comprising
a third step of repeatedly performing, by a decoding unit, a row operation processing and a column operation processing in decoding using one of the first check matrix and the second check matrix.

15. The check matrix generation method according to claim 14, wherein
the decoding unit performs, in the row operation processing of the third step, masking on blocks of submatrices replaced with the zero matrices and shifting that shifts back blocks of submatrices shifted by the fixed value, to perform same operation as a row operation processing performed for the first check matrix even when a check matrix with a different code rate is used.

16. The check matrix generation method according to claim 14 or 15, wherein
the decoding unit performs, in the column operation processing of the third step, masking on blocks of submatrices replaced with the zero matrices, to perform same operation as a column operation processing performed for the second check matrix with the code rate that is lowest even when a check matrix with a different code rate is used.
